# EUROPEAN PATENT APPLICATION

(11) **EP 4 503 880 A1**
(43) Date of publication of application: **05.02.2025**
(21) Application number: 22938614.9
(22) Date of filing: 19.04.2022
(51) Int. Cl.: H05K 7/20, B01D 45/14

(54) **DISPLAY DEVICE**

(71) Applicant: LG Electronics Inc., Yeongdeungpo-gu Seoul 07336 (KR)
(72) Inventor: HAN, Sungwook, Seoul 06772 (KR); HAN, Byoungwook, Seoul 06772 (KR); KWON, Seonghun, Seoul 06772 (KR); KIM, Joongnyon, Seoul 06772 (KR); KANG, Hyeonjin, Seoul 06772 (KR)
(74) Representative: Vossius & Partner Patentanwälte Rechtsanwälte mbB
(86) International application number: PCT/KR2022/005616
(87) International publication number: WO 2023/204322

(57) **Abstract**

Provided is a display device comprising: a display module; a housing in which the display module is mounted therein; a first opening which is formed in the lower portion of the housing so that external air can flow in the housing; a second opening formed in the upper portion of the housing so that the air in the housing is discharged to the outside; and a cyclone filter which is located in the first opening and removes dust from the air flowing into the housing, wherein the cyclone filter comprises: a filter case having a cylindrical shape; a gas inlet through which the air flows into the inside of the filter case; a dust outlet which discharges the dust isolated from the air flowing into the filter case; a gas outlet which is located on the upper portion of the filter case and supplies the air into the housing; and a suction fan which sucks the air so that the dust can be flowed in through the gas inlet.

## Description

### [Technical Field]

The present disclosure relates to a display device including a heat dissipation structure that is easy to maintain.

### [Background Art]

Display devices include a display that outputs images, and various types of display devices are available depending on the size of the display. In particular, as displays have recently become thinner and are manufactured using various materials, more diverse types of display devices have been introduced.

There are various types of display devices, including portable display devices, indoor display devices, and outdoor display devices. In the case of portable displays, thin and light displays with high resolution are used to display various images on a small screen.

Indoor displays are becoming larger and thinner than in the past as display technology improves. The development of flexible displays has led to the development of curved display devices and rollable displays.

Recently, display devices that provide various kinds of content and messages through display devices rather than hardware media, such as outdoor advertisement signboards and posters, have been used. Recently, there is a need for large display devices with the rapid development of LED and OLED-based smart digital imaging devices.

A typical example of a large display is digital signage, which is a communication tool that can induce marketing, advertising, and training effects for companies, and uses experience. The digital signage is a display device that provides specific information as well as broadcast programs in public places such as airports, hotels, hospitals, and subway stations.

Some types of display devices are designed with a large (large-inch) display mounted therein, and are sometimes located outside where there are a lot of foreign substances such as dust or the surrounding temperature difference is large.

Under such environmental conditions, the display device must have relatively high luminance for sufficient outdoor visibility, and is likely to be left at a high temperature outside, so that a structure capable of efficiently dissipating heat generated when driving the display is required.

Therefore, an air circulation method or an air circulation structure through the internal or external structure of the display device for efficient heat dissipation is required.

For heat dissipation, a circulation method for introducing and cooling outside air is used, and when outside air is introduced into a display device installed outdoors, contaminants such as dust can also be easily introduced into the display device, so that a filter structure that can remove such contaminants is essential.

General filters require periodic cleaning and replacement. As such, it is difficult to easily maintain and repair such general filters, and filter waste is also generated, so there is a need for improved filters that can be reused or permanently used from an environmental standpoint.

### [Disclosure]

### [Technical Problem]

An object of the present disclosure is to provide a display device including a heat dissipation structure that is easy to maintain.

### [Technical Solutions]

In accordance with an aspect of the present disclosure, a display device may include: a display module; a housing including a display module mounted therein; a first opening formed at a lower portion of the housing and allowing external air to be introduced into the housing; a second opening formed at an upper portion of the housing and allowing air inside the housing to be discharged outside; and a cyclone filter located at the first opening and removing dust from the air introduced into the housing. The cyclone filter may include: a cylindrical filter case; a gas inlet through which air is introduced into the filter case; a dust outlet through which dust separated from the air introduced into the filter case is discharged outside; a gas outlet located at an upper portion of the filter case and supplying air into the housing; and a suction fan configured to suck in dust so that the dust is introduced through the gas inlet.

The housing may include: a first space located at a front surface of the display module; and a second space located at a back surface of the display module, wherein the air introduced through the first opening moves between the first space and the second space and circulates inside the housing.

The display device may further include a flow path guide located adjacent to the second opening and configured to guide air from the second space to the first space.

The air introduced through the first opening may move to the second space; and the display device may further include a circulation fan configured to supply air from the second space to the first space.

The display device may further include: a controller disposed in the second space and configured to control the display module, the suction fan, and the circulation fan.

The display device may further include: a temperature sensor configured to measure a temperature of the housing. The controller is configured to: control the suction fan so that a revolutions per minute (RPM) increases as the temperature of the housing increases; and control the suction fan so that the revolutions per minute (RPM) decreases as the temperature of the housing decreases.

The display device may further include: in a situation where the revolutions per minute (RPM) of the suction fan is a minimum RPM, when the temperature of the housing decreases, the revolutions per minute (RPM) of the circulation fan decreases.

The display device may further include: a temperature sensor configured to measure the temperature inside the housing. The cyclone filter may be implemented as a plurality of cyclone filters. The controller may be configured so that, as the temperature inside the housing increases, the number of suction fans to be driven from among the plurality of cyclone filters increases; and the controller may be configured so that, as the temperature inside the housing decreases, the number of suction fans to be driven from among the plurality of cyclone filters decreases.

The dust outlet may be located at a bottom of the filter case; and the filter case may be formed in a cone shape that extends from the bottom of the filter case to the dust outlet.

The suction fan may be disposed at the gas outlet.

The gas inlet may be located at the bottom of the filter case; and the suction fan may be located at the gas inlet.

The dust outlet may be located in a side direction of the filter case.

The display device may further include: a dustbin configured to collect dust to be discharged from the dust outlet.

The cyclone filter may include one suction fan and a plurality of filter cases.

### [Advantageous Effects]

The display device according to the present disclosure has the following effects.

According to at least one of the embodiments of the present disclosure, there is an advantage in that heat dissipation efficiency can be increased by using a direct cooling method.

According to at least one of the embodiments of the present disclosure, a filter that filters out dust from external air can be easily managed, thereby increasing convenience in maintenance.

In addition, according to at least one of the embodiments of the present disclosure, the filter need not be replaced or cleaned so that the filter can be used permanently, so there is no need to replace or discard the filter.

Further scope of applicability of the present disclosure will become apparent from the following detailed description. Various changes and modifications within the spirit and scope of the present disclosure can be clearly understood by those skilled in the art, and therefore it is to be understood that the detailed description and specific embodiments such as preferred embodiments of the present disclosure are given by way of example only.

### [Description of Drawings]

FIG. 1 is a block diagram illustrating a display device related to the present disclosure.
FIG. 2 is a perspective view illustrating a display device according to one embodiment of the present disclosure.
FIG. 3 is a cross-sectional view illustrating a display device according to one embodiment of the present disclosure.
FIG. 4 is a cross-sectional view illustrating a display device according to another embodiment of the present disclosure.
FIG. 5 is a table illustrating characteristics according to types of cyclone filters according to the present disclosure.
FIG. 6 is a table illustrating another example of a cyclone filter according to the present disclosure.
FIG. 7 is a graph and table illustrating performance of one example of the cyclone filter shown in FIG. 6 according to the present disclosure.
FIG. 8 is a cross-sectional view illustrating a display device according to another embodiment of the present disclosure.

### [Best Mode]

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

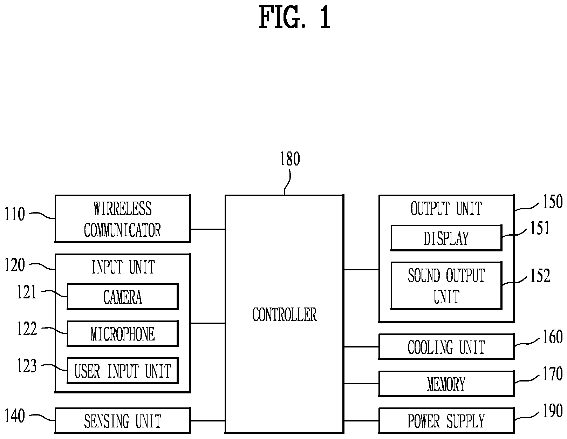

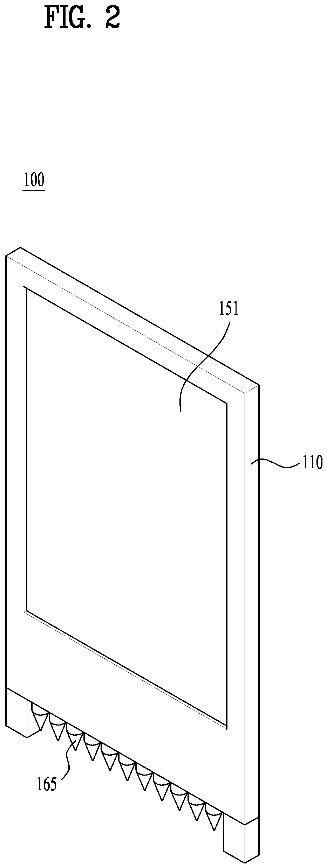

FIG. 1 is a block diagram illustrating a display device 100 related to the present disclosure. FIG. 2 is a perspective view illustrating a display device 100 according to an embodiment of the present disclosure.

The display device 100 may include a wireless communicator 110, an input unit 120, a sensing part 140, an output unit 150, a cooling part 160, a memory 170, a controller 180, and a power supply 190. The components shown in FIG. 1a are not essential to implement the display device 100, and the display device 100 described herein may have more or fewer components than those listed above.

More specifically, the wireless communicator 110 among the components may include one or more modules that enable wireless communication between the display device 100 and a wireless communication system, between the display device 100 and another display device 100, or between the display device 100 and an external server. Additionally, the wireless communicator 110 may include one or more modules that connect the display device 100 to one or more networks.

The wireless communicator 110 may include at least one of a mobile communication module, a wireless internet module, or a short-range communication module.

The input unit 120 may include a camera 121 or image input unit configured to input an image signal, a microphone 122 or audio input unit configured to input an audio signal, and a user input unit 123 (e.g., a touch key, a mechanical key, etc.) configured to input information from a user. Voice data or image data collected by the input unit 120 may be analyzed and processed as control commands from the user.

The user input unit may include a touch sensor disposed on the front of the display 151. The touch sensor may be disposed on the entire front of the display 151. For a large display, the touch sensor may be disposed on a portion of the display in consideration of the reach of the user.

The sensing part 140 may include one or more sensors configured to sense at least one of information in the display device 100, information about the environment surrounding the display device 100, or user information. For example, the sensing part 140 may include at least one of a proximity sensor, an illumination sensor, a touch sensor, an RGB sensor, an infrared (IR) sensor, a finger scan sensor, an ultrasonic sensor, an optical sensor (e.g., the camera 121), a microphone (see 122), a battery gauge, an environmental sensor (e.g., a barometer, a hygrometer, a thermometer, a radiation detection sensor, a heat detection sensor, a gas detection sensor, etc.), a chemical sensor (e.g., an electronic nose, a healthcare sensor, or a biometric sensor, etc.). The display device 100 disclosed herein may utilize pieces of information sensed by at least two of these sensors in combination.

The output unit 150 is configured to generate outputs related to visual, auditory, or tactile senses, and may include at least one of a display unit 151 and a sound output unit 152. The display unit 151 may be layered or integrally formed with the touch sensor, thereby implementing a touchscreen. Such a touch screen may function as the user input unit 123 to provide an input interface between the display device 100 and a user, and may provide an output interface between the display device 100 and the user.

The cooling part 160 represents a component that dissipates heat from the display device 100, and may include heat pipes or cooling fins, and a circulating fan configured to enhance air circulation within the display device 100, and a vent hole or the like.

When installed for the purpose of exhibition or advertisement, the display device 100 is operated for a long time and outputs high luminance to be clearly visible from the outside. Therefore, the heat generated by the display 151 and the controller 180 may affect each part of the display device 100, resulting in malfunctions, etc. Therefore, a heat dissipation structure to dissipate the internal heat is very important.

In the display device 100, heat dissipation is implemented in various ways. Depending on how heat transfer is performed during the heat dissipation process, heat dissipation may be divided into air-cooling or water-cooling. In the case of air-cooling, heat dissipation efficiency can be increased by maximizing the surface area using heat fins or the like. In the case of water-cooling, heat dissipation efficiency can be increased by using a structure such as a heat pipe to guide flow and sealing of the heat transfer material.

Any of these cooling methods for heat dissipation may be used alone, or two or more of these methods may be used in combination as needed.

Among the above-described heat dissipation methods, the air-cooling method may include a direct cooling method in which external air is directly introduced into the display device but a filter is used to filter out dust and inflows, and/or an indirect cooling method in which external air and internal air of the display device are basically blocked using a heat exchanger to only exchange heat with each other.

Due to characteristics of the display device exposed to the outside with a lot of foreign substances such as dust, the indirect cooling method may be a good alternative. However, the indirect cooling method may have problems with heat dissipation efficiency because a heat generation area and the external air do not directly -exchange heat with each other.

In particular, in the display device, high heat is generated at multiple points, such as heat generated from a front panel of a display module, heat generated from a rear backlight unit of the display module, and heat generated from other electronic components. Therefore, if the above-described display modules are configured as a single circulation structure, internal air that has not been exchanged heat passes through another heating area without any change, so that sufficient heat exchange may not occur.

However, the direct cooling method requires periodic replacement of filters designed to purify external air, so that manpower must be invested in system maintenance, and additional costs required for filter replacement may be required.

Therefore, the display device according to the present disclosure includes a cyclone filter, so that the display device can solve difficulty of system maintenance according to filter replacement, thereby improving the durability of the display device.

The memory 170 stores data that supports various functions of the display device 100. Display device display device. The memory 170 may store multiple application programs or applications running on the display device 100, data for operation of the display device 100, and instructions. At least some of these applications may be downloaded from an external server through wireless communication. In addition, at least some of these applications may be present on the display device 100 from the time of shipment for basic functions of the display device 100 (e.g., making and receiving calls, receiving messages, and sending messages). The applications may be stored in the memory 170, installed on the display device 100, and driven by the controller 180 to perform an operation (or function) of the display device 100.

In addition to operations related to the applications, the controller 180 generally controls the overall operation of the display device 100. The controller 180 may provide or process appropriate information or functions for the user by processing signals, data, information, etc. that are input or output through the components discussed above, or by driving applications stored in the memory 170.

Further, the controller 180 may control at least some of the components to run the applications stored in the memory 170. Further, the controller 180 may operate at least two of the components included in the display device 100 in combination to drive the applications.

The power supply 190 receives power from an external power source or an internal power source and provides power to each of the components included in the display device 100, under control of the controller 180. The power supply 190 may include a battery, which may be a built-in battery or a replaceable battery.

At least some of the components may operate in cooperation with each other to implement operation or control of the display device 100 or a method therefor according to various embodiments described below. Additionally, the operation or control of the display device 100 or the method therefor may be implemented on the display device 100 by driving at least one application stored in the memory 170.

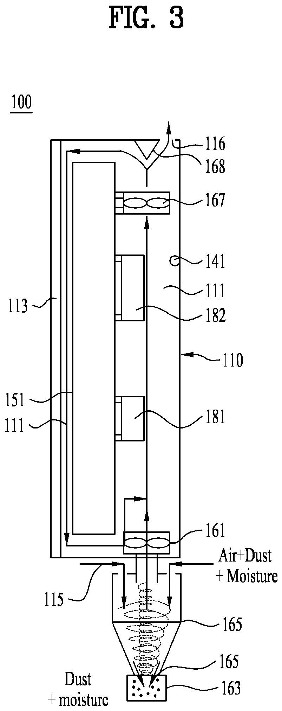

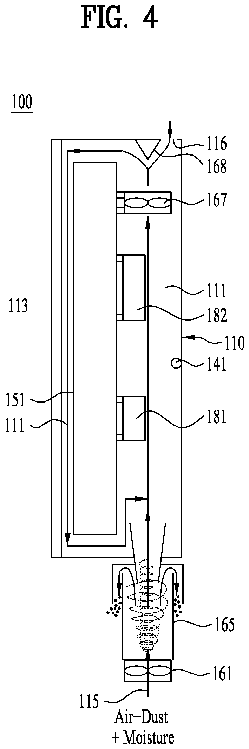

FIG. 3 is a cross-sectional view illustrating a display device 100 according to one embodiment of the present disclosure. FIG. 4 is a cross-sectional view illustrating a display device 100 according to another embodiment of the present disclosure. FIG. 3 and FIG. 4 basically have the same internal structure of a housing 110, and differ only in the structure of the filter located at the bottom of the internal structure.

The display device 100 according to the present disclosure may include the housing 110 formed in a rectangular box shape. Although the housing 110 is depicted as being made of a single member in the drawing, the housing 110 may have a form in which a cover on the back surface is provided separately.

The display module mounted inside the housing 110 includes a plurality of light emitting devices, and unlike the conventional backlight unit type, light is generated from the light emitting devices of each pixel, so that heat may be emitted toward the front of the display module.

The housing 110 may include a first space 111 located at the front surface based on the display module and a second space 112 located at the back surface based on the display module. The first space 111 on the front surface may include a transparent glass 113 located at the front surface of the housing 110 so that the display module is visible, and the second space 112 may refer to the space between the back surface of the display module and the back surface of the housing 110.

The transparent glass 113 may be integrally formed with the housing 110, or if the transparent glass 113 is a detachable type, the transparent glass 113 may be removed to expose the inside of the housing 110.

As a controller for driving the display module on the back surface of the display module, a main board and a program memory unit (PSU) may be mounted. The controller may be fixed to the back surface of the display module or may be fixed to the housing 110.

That is, the controller may be mounted in the second space 112. The controller may also generate a lot of heat when operating, and the controller may contact the housing 110 located at the back surface to emit heat.

The first space 111 and the second space 112 may be configured such that heat can be emitted from the display module or the controller. The display device 100 is a large display device 100 used outdoors, so that the amount of emitted heat is also large.

If the temperature of the housing 110 rises, malfunction of electronic components located inside the housing 110 may become problematic, and if the user inadvertently touches the housing 110, there is a risk of burns, so that a cooling unit 160 that lowers the temperature of the housing 110 is essential.

The housing 110 may include a first opening 115 through which cold air from the outside is introduced and a second opening 116 through which hot air is discharged. As the temperature of the air introduced into the housing 110 becomes lower, the specific gravity becomes higher, so that the air moves downward. As the temperature of the air introduced into the housing 110 becomes higher, the air moves upward. Accordingly, the lower the temperature of the air introduced into the housing 110, the higher the heat dissipation efficiency, so that the first opening 115 may be located at the bottom of the housing 110, as shown in FIG. 3.

The external cold air may be introduced into the housing 110 and the internal hot air may be discharged outside, so that the temperature of the housing 110 and the temperature of the inside of the housing 110 can be lowered. However, the air introduced into the inside of the housing 110 through the first opening 115 contains dust or foreign substances, so if the air is supplied into the inside of the housing 110 without any change, malfunction of the display module and the controller may occur, the front surface of the display module may be contaminated, deteriorating visibility.

Accordingly, the air introduced into the first opening 115 needs to pass through a filter to remove dust, etc. In the related art, a filter designed to use a woven structure such as mesh or fabric was placed in the first opening 115 to remove contaminants from the air so that only clean air can flow into the housing. However, such filter should be cleaned and reused or it is difficult for this filter to be reused so that the filter should be replaced with a new one, thereby causing additional costs and difficulty in maintenance.

Therefore, the present disclosure can remove foreign substances such as dust using a cyclone filter 165 that does not require replacement. The cyclone filter 165 may use centrifugal force so that light air moves upward and foreign substances such as heavy dust move downward, thereby purifying the air.

The cyclone filter 165 may include a cylindrical filter case, and air inside the filter case rotates in a spiral shape along the outer circumferential surface of the filter case, so that air and dust can be separated from each other.

Dust may be pushed toward a wall surface of the filter case by centrifugal force. Moisture is heavier than air, so that the moisture can be separated from the air. As a result, it is possible to prevent moisture from penetrating into the housing 110.

A suction fan 161 for suctioning air to allow the air to pass through the cyclone filter 165 is required, and the suction fan 161 may be located at a gas outlet or a gas inlet depending on the shape of the cyclone filter 165.

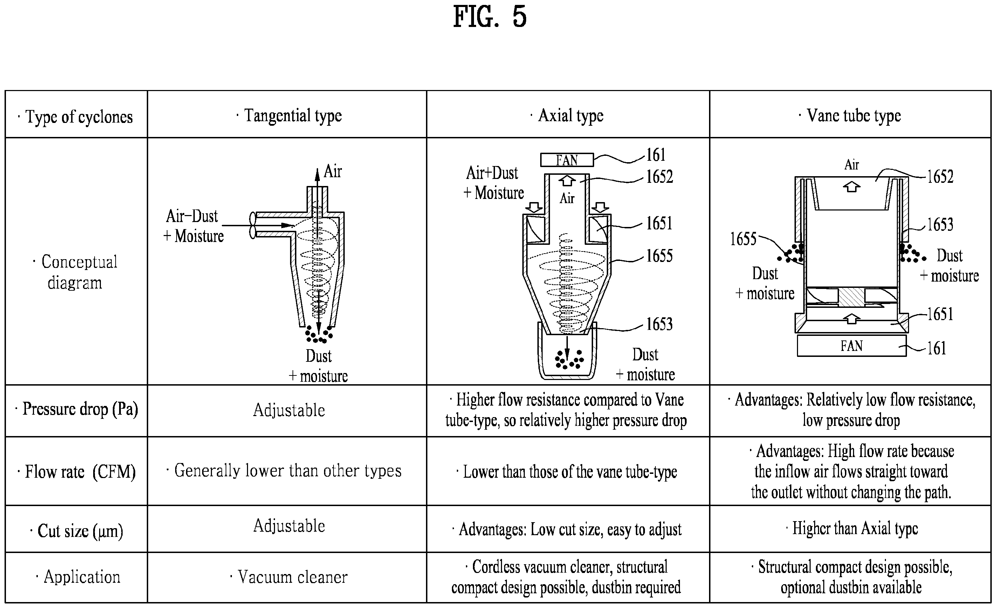

FIG. 5 is a table illustrating characteristics of the cyclone filter 165 according to various types of the cyclone filter 165. The tangential cyclone filter 165 is a cyclone filter used in vacuum cleaners in which air is introduced from the side direction, dust is discharged downward, and air is discharged upward.

There is no exact data on the pressure or the size of dust removed, but the flow rate is low. The tangential cyclone filter 165 aims to suck in dust, so the amount of air to be discharged is not considered. When air is discharged at a high pressure, it may cause discomfort to the user, so the pressure of the discharged air may be weakened.

However, since the amount of air discharged into the housing 110 of the cyclone filter 165 is of importance, a cyclone filter 165 of a different type from that used in household vacuum cleaners can be used.

The axial cyclone filter 165 is configured such that the suction fan 161 is located at the outlet instead of the inlet, thereby securing the flow rate to be discharged. The embodiment of FIG. 3 is an embodiment using the axial cyclone filter 165.

The display device shown in FIG. 3 has a gas inlet formed around the upper portion of the filter case, and dust is discharged in a downward direction. In order to guide dust in a downward direction, the filter case may have a shape in which a diameter in the downward direction becomes smaller.

The cyclone filter 165 according to the present embodiment requires a dustbin 163 to collect dust and moisture that have moved downward. When the dustbin 163 is filled with dust, the dust should be discarded from the dustbin 163, so periodic management of the dustbin 163 is required.

The cyclone filter 165 is configured such that air is introduced from the side direction and moves upward, so the direction of the air changes within the cyclone filter 165. Since the flow path is not straight but bent, the flow rate of the air introduced into the housing 110 may decrease.

The suction fan 161 is located above the cyclone filter 165 and may be located within the housing 110 as shown in FIG. 3. Since the air purified through the cyclone filter 165 passes through the suction fan 161, the suction fan 161 has the advantage of not being contaminated.

Meanwhile, the vane tube-type cyclone filter 165 has a gas inlet at the bottom thereof and dust is discharged in the side direction. Dust and moisture are discharged through the dust outlet located in the side direction, and unlike the embodiment of FIG. 3, a cylindrical shape that narrows downward is unnecessary.

In addition, the dust outlet arranged on the side is arranged along the circumference of the cyclone filter 165, so that dust is not discharged from only one place. As a result, there is no need to necessarily have a separate dustbin.

The display device 100 of FIG. 4 is an embodiment in which the vane tube-type cyclone filter 165 is applied and the suction fan 161 is located at the gas inlet. Since the air passing through the suction fan 161 is in a state in which the dust is not yet removed from the air, the fan may be contaminated. However, since the air flow is in a straight line in an upward direction, flow resistance is relatively low so that the pressure drop is low.

Since the gas inlet and the gas outlet are in a straight line, it is advantageous in securing the flow rate. However, since the air is not introduced from the outer surface of the filter case in the same manner as in the axial cyclone filter, centrifugal force is weak, and filter performance is restricted.

In the table of FIG. 5, the term "cut size" is a minimum cutting diameter of removable dust, as the cut size becomes smaller, filter performance becomes higher. The cutting diameter of the removable dust of the axial cyclone filter is smaller than that of the vane tube-type cyclone filter.

Hereinafter, description will be given on the basis of the axial cyclone filter 165 in consideration of the function as a filter for reducing the size of dust introduced therein, but the scope of the present disclosure is not necessarily limited thereto. The vane tube-type cyclone filter can also improve dust removal performance, i.e. the performance as a filter, by adjusting the size of the filter case, the performance of the fan, etc.

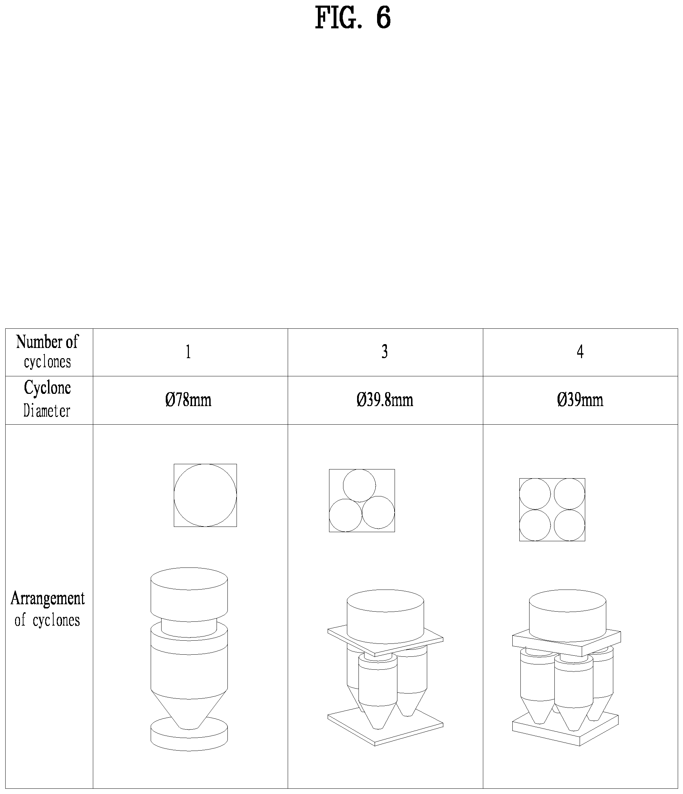

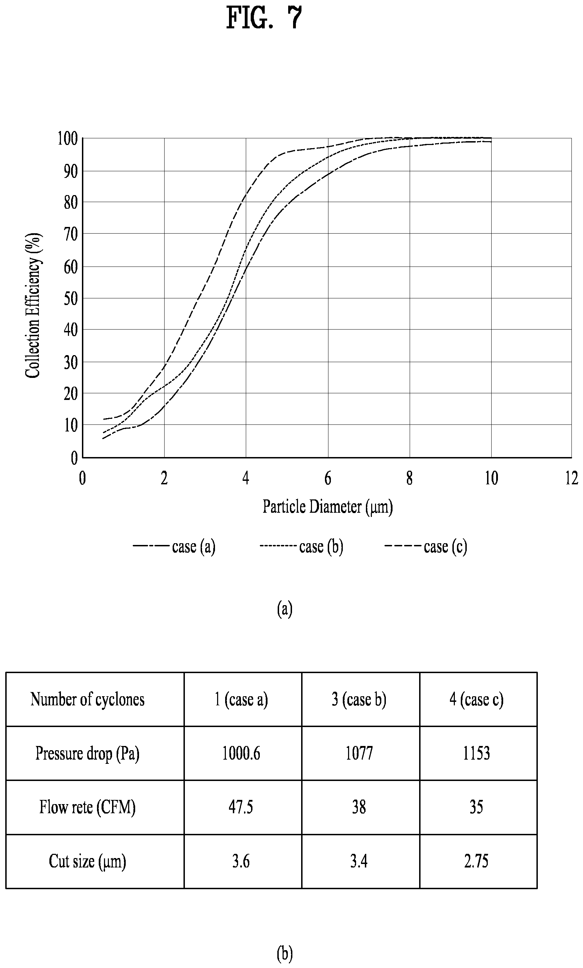

FIG. 6 is a table illustrating another example of the cyclone filter according to the present disclosure. FIG. 7 is a graph and table illustrating performance of one example of the cyclone filter shown in FIG. 6 according to the present disclosure.

As shown in FIG. 6, a cyclone filter may include multiple cyclone filters in one suction fan. As the number of cyclone filters increases, the diameter of each cyclone becomes smaller.

Referring to the graph and table of FIG. 7, as the number of cyclone filters increases (case A → case B), the air flows emerging from each cyclone filter collide with each other, which lowers the pressure of the air supplied into the housing and also reduces the flow rate.

However, as the number of cyclone filters increases, the diameter of the cyclone filter becomes smaller, thereby reducing the size of removable dust.

The cyclone filter according to the present disclosure is designed not only for removing dust but also for measurement of the amount of air to be supplied to the inside of the housing. Therefore, the number of cyclones can be determined by considering the size of the dust to be removed and the amount of air to be discharged.

When the air introduced into the housing 110 through the cyclone filter 165 is discharged to the second opening 116, the air must be continuously introduced into the housing 110 using the filter. As a result, the lifespan of the suction fan 161 and the cyclone filter 165 may decrease, power consumption may increase, and even if the dust in the outside air is removed using the cyclone filter 165, a certain level of dust may be introduced into the housing 110, which may affect the durability of the display device 100.

Therefore, if the temperature of the housing 110 is not high, it is desirable to circulate the air introduced through the first opening 115 within the housing 110 as much as possible to sufficiently utilize the air for cooling. The display device may further include a flow path guide 168 located within the housing 110 so that the air introduced through the first opening 115 can be circulated within the housing without being discharged directly through the second opening 116.

The flow path guide 168 may form a circulation path so that the air circulates within the first space 111 located at the front of the display module and the second space 112 located at the rear of the display module, and thus the circulating air can absorb heat generated from the display module and the controller.

The air flowing into the first opening 115 flows in a straight line, so that the air can flow into the wide second space 112. The flow path guide 168 can guide the air moving upward from the second space 112 to move to the first space 111 instead of being directly discharged to the second opening 116 located above the second space 112.

A circulation fan 167 may be further included inside the housing 110. The circulation fan 167 can supplement performance of the suction fan 161 to secure the flow rate to be introduced into the housing 110 and at the same time may promote the flow of air inside the housing 110.

The circulation fan 167 can be operated independently from the suction fan 161 and can be provided in a different number of suction fans 161. As shown in FIGS. 3 and 4, the suction fan 161 is located above the housing 110 so that the air introduced into the second space 112 can move upward and quickly circulate toward the first space 111 by increasing the flow rate/volume.

The operation of the suction fan 161 and the circulation fan 167 can be controlled according to the temperature of the housing 110 and may further include a temperature sensor 141 located inside the housing 110. The controller may control the suction fan 161 and the circulation fan 167 of the display device 100 based on the temperature measured by the temperature sensor 141.

For example, when the temperature of the housing 110 increases, the hot air inside the housing 110 must be discharged and new cold air must be introduced into the housing 110, so that the revolutions per minute (RPM) of the suction fan 161 can increase. As the rotation speed (rpm) of the suction fan 161 increases, the flow rate increases and the centrifugal force increases, so that the cutting diameter of the inflowing dust can also be reduced.

However, when the housing 110 is at a low temperature, cooling is not necessary, so that the rotation speed (rpm) of the suction fan 161 can be lowered to reduce the amount of air to be introduced into the housing 110. However, if the suction fan 161 is turned off or the rotation speed is too low, performance of the cyclone filter 165 may be deteriorated. Since the centrifugal force is not sufficient to remove dust, a minimum rotation speed (rpm) of the suction fan 161 can be set so that dust larger than the standard cutting diameter is not introduced into the housing 110.

For example, in order to maintain the cutting diameter of the inflow dust at 5 µm or less, the required rotation speed (rpm) can be set to the minimum rotation speed, and if the temperature decreases even when the suction fan 161 is driven at the minimum rotation speed, the rotation speed (rpm) of the circulation fan 167 located inside the housing 110 may decrease.

Since active (aggressive) cooling is not required, the amount of air to be introduced into the housing 110 can be minimized and the amount of air to be circulated within the housing 110 can also be minimized.

In the case where the suction fan 161 is stopped, a cover that completely blocks the intake of air into the gas inlet of the cyclone filter 165 may be further included in the housing according to the present disclosure. For example, in the case where a plurality of cyclone filters 165 is provided in the housing, only some of the suction fans 161 may be driven and the remaining suction fans may not be driven, and at this time, the gas inlet of the cyclone filter 165 can be covered.

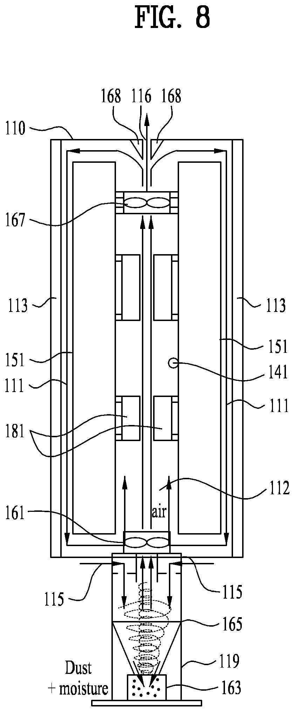

FIG. 8 is a cross-sectional view illustrating a display device 100 according to another embodiment of the present disclosure. Referring to FIG. 8, the display device 100 may include a display module provided on both sides of the housing 110. In order to place the display module on both sides of the housing 110, the housing 110 may include glasses 113 on both sides thereof, and may include two first spaces 111. Meanwhile, the second space 112 located on the back of the display module may be configured as one space as illustrated in FIG. 8.

The cyclone filter 165 is located below the second space 112 and may be disposed between two support legs 119 that support the bottom of the display device. The upper portion of the cyclone filter 165 is located inside the first opening 115, and the lower portion of the cyclone filter 165 may protrude, and a cover (not shown) coupled to both surfaces may be further included to cover such protrusion. \

It will be apparent to those skilled in the art that the present disclosure can be embodied in other specific forms without departing from the spirit and essential features of the present disclosure.

The detailed description above is not to be construed as limiting in any aspect and should be considered exemplary. The scope of this disclosure shall be determined by a reasonable interpretation of the appended claims. Thus, it is intended that the present disclosure cover the modifications and variations of this disclosure provided they come within the scope of the appended claims and their equivalents.

## Claims

1. A display device comprising:
a display module;
a housing including a display module mounted therein;
a first opening formed at a lower portion of the housing and allowing external air to be introduced into the housing;
a second opening formed at an upper portion of the housing and allowing air inside the housing to be discharged outside; and
a cyclone filter located at the first opening and removing dust from the air introduced into the housing,
wherein the cyclone filter includes:
a cylindrical filter case;
a gas inlet through which air is introduced into the filter case;
a dust outlet through which dust separated from the air introduced into the filter case is discharged outside;
a gas outlet located at an upper portion of the filter case and supplying air into the housing; and
a suction fan configured to suck in dust so that the dust is introduced through the gas inlet.

2. The display device according to claim 1, wherein the housing includes:
a first space located at a front surface of the display module; and
a second space located at a back surface of the display module,
wherein
the air introduced through the first opening moves between the first space and the second space and circulates inside the housing.

3. The display device according to claim 2, further comprising:
a flow path guide located adjacent to the second opening and configured to guide air from the second space to the first space.

4. The display device according to claim 2, wherein:
the air introduced through the first opening moves to the second space; and
the display device further includes a circulation fan configured to supply air from the second space to the first space.

5. The display device according to claim 4, further comprising:
a controller disposed in the second space and configured to control the display module, the suction fan, and the circulation fan.

6. The display device according to claim 5, further comprising:
a temperature sensor configured to measure a temperature of the housing,
wherein the controller is configured to:
control the suction fan so that a revolutions per minute (RPM) increases as the temperature of the housing increases; and
control the suction fan so that the revolutions per minute (RPM) decreases as the temperature of the housing decreases.

7. The display device according to claim 6, further comprising:
in a situation where the revolutions per minute (RPM) of the suction fan is a minimum RPM, when the temperature of the housing decreases, the revolutions per minute (RPM) of the circulation fan decreases.

8. The display device according to claim 5, further comprising:
a temperature sensor configured to measure the temperature inside the housing,
wherein
the cyclone filter is implemented as a plurality of cyclone filters;
the controller is configured so that, as the temperature inside the housing increases, the number of suction fans to be driven from among the plurality of cyclone filters increases; and
the controller is configured so that, as the temperature inside the housing decreases, the number of suction fans to be driven from among the plurality of cyclone filters decreases.

9. The display device according to claim 1, wherein:
the dust outlet is located at a bottom of the filter case; and
the filter case is formed in a cone shape that extends from the bottom of the filter case to the dust outlet.

10. The display device according to claim 9, wherein:
the suction fan is disposed at the gas outlet.

11. The display device according to claim 1, wherein:
the gas inlet is located at the bottom of the filter case; and
the suction fan is located at the gas inlet.

12. The display device according to claim 11, wherein:
the dust outlet is located in a side direction of the filter case.

13. The display device according to claim 1, further comprising:
a dustbin configured to collect dust to be discharged from the dust outlet.

14. The display device according to claim 1, wherein:
the cyclone filter includes one suction fan and a plurality of filter cases.
